# EUROPEAN PATENT APPLICATION

(11) **EP 4 411 822 A1**
(43) Date of publication of application: **07.08.2024**
(21) Application number: 23154769.6
(22) Date of filing: 02.02.2023
(51) Int. Cl.: H01L 29/06, H01L 21/762, H01L 29/40, H01L 29/78

(54) **SEMICONDUCTOR DEVICE AND METHOD OF FABRICATING AN ELECTRICALLY INSULATING STRUCTURE IN A TRENCH**

(71) Applicant: Infineon Technologies Austria AG, 9500 Villach (AT)
(72) Inventor: ALTSTÄTTER, Christof, 9908 Amlach (AT); NEUMANN, Ingmar, 9500 Villach (AT); BLANK, Oliver, 9500 Villach (AT); HOFER, Heimo, 9551 Steindorf (AT)
(74) Representative: JENSEN & SON

(57) **Abstract**

In an exemplary embodiment, a semiconductor device comprises a semiconductor substrate having a first major surface, a trench positioned in the semiconductor substrate and having a width, a base and a side wall extending from the base to the first major surface, a first electrically insulating layer that lines the base and side wall of the trench and an electrically insulating plug that is positioned in the trench and that extends across the entire width of the trench. The plug has a lower surface that forms an interface with the first electrically insulating layer and an upper surface. The upper surface of the plug is coplanar with the first major surface of the semiconductor substrate or positioned within the trench.

## Description

### BACKGROUND

A semiconductor device may include a semiconductor substrate having an active area in which the active device structures are formed and an edge termination region that laterally surrounds the active area. One or more trenches may be formed in the edge termination region and/or active area. One of more of these trenches may comprise and, in some designs, may be filled with electrically insulating material.

Transistor devices used in power electronic applications are often fabricated with silicon (Si) semiconductor materials. Common transistor devices for power applications include Si CoolMOSO, Si Power MOSFETs and Si Insulated Gate Bipolar Transistors (IGBTs). A transistor device for power applications may be based on the charge compensation principle and may include an active cell field including a plurality of trenches, each including a field plate for charge compensation. In some designs, the trenches and the mesas that are formed between adjacent trenches each have an elongate striped structure. In some other designs, the trenches have a columnar needle-like shape, as for example disclosed in DE 10 2014 112371 A1. An edge termination structure which laterally surrounds the active cell field may be used to avoid breakdown of the semiconductor device due to edge effects and to improve the performance of the device.

It would be desirable to further improve the performance of semiconductor devices, such as MOSFET devices.

### SUMMARY

In an exemplary embodiment, a semiconductor device comprises a semiconductor substrate having a first major surface, a trench positioned in the semiconductor substrate and having a width, a base and a side wall extending from the base to the first major surface, a first electrically insulating layer that lines the base and side wall of the trench and an electrically insulating plug that is positioned in the trench and that extends across the entire width of the trench. The plug has a lower surface that forms an interface with the first electrically insulating layer and an upper surface. The upper surface of the plug is coplanar with the first major surface of the semiconductor substrate or positioned within the trench.

In an exemplary embodiment, a method of fabricating an electrically insulating structure in a trench is provided, whereby the method comprises forming a trench in a first major surface of a semiconductor substrate, forming a first electrically insulating layer on the base and side walls of the trench and forming an electrically insulating plug within the trench and on the first electrically insulating layer such that the plug has a lower surface forming an interface with the first electrically insulating layer and an upper surface that is coplanar with the first major surface of the semiconductor substrate or positioned within the trench.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1, which includes figures 1A to 1C, illustrates a trench comprising electrically insulating material according to various embodiments.
Figure 2, which includes figures 2A to 2D, illustrates a method of fabricating a trench comprising electrically insulating material.
Figure 3 illustrates a top view of a semiconductor device having an active area and an edge termination region.
Figure 4 illustrates a cross-sectional view of a portion of the semiconductor device of figure 3.
Figure 5 illustrates a cross-sectional view of a semiconductor device according to an embodiment.
Figure 6 illustrates a top view of a portion of the semiconductor device of figure 4.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, various device types and/or doped semiconductor regions may be identified as being of n type or p type, but this is merely for convenience of description and not intended to be limiting, and such identification may be replaced by the more general description of being of a "first conductivity type" or a "second, opposite conductivity type" where the first type may be either n or p type and the second type then is either p or n type.

The Figures illustrate relative doping concentrations by indicating "-" or "+" next to the doping type "n" or "p". For example, "n-" means a doping concentration which is lower than the doping concentration of an "n"-doping region while an "n⁺"-doping region has a higher doping concentration than an "n"-doping region. Doping regions of the same relative doping concentration do not necessarily have the same absolute doping concentration. For example, two different "n"-doping regions may have the same or different absolute doping concentrations.

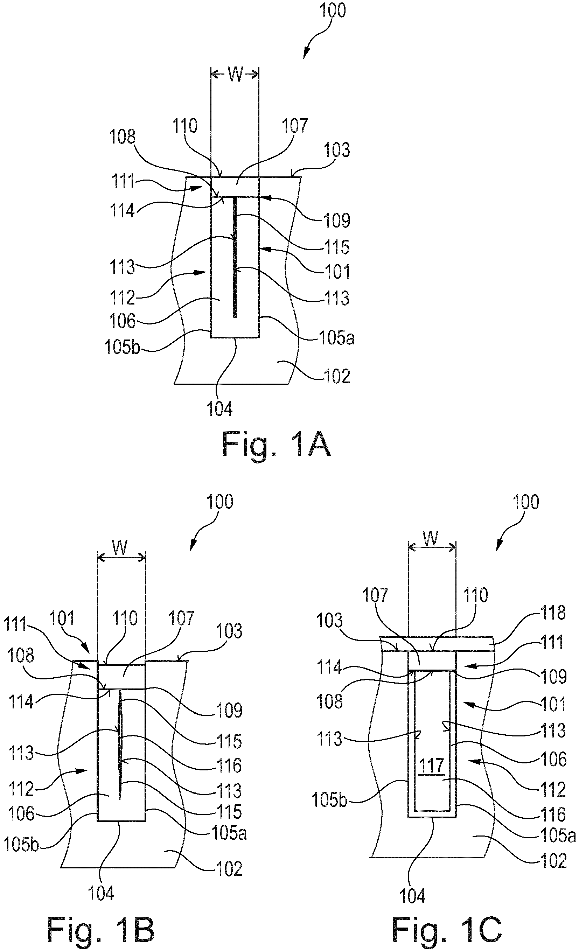

Figure 1, which includes figures 1A to 1C, illustrates cross-sectional views of a semiconductor device 100 comprising a trench 101. The semiconductor device 100 comprises a semiconductor substrate 102 having a first major surface 103. The trench 101 is positioned in the first major surface 103 of the semiconductor substrate 102 and has a base 104 and a sidewall 105 extending from the base 104 to the first major surface 103 of the semiconductor substrate 102. The semiconductor substrate 102 may comprise silicon, for example monocrystalline silicon or an epitaxial silicon layer.

The trench 101 may have different lateral shapes in the top view. However, the structure in the cross-sectional view is the same for the different lateral shapes in top view. In some embodiments, the trench 101 has an elongate structure with its length, i.e. the longest direction, extending into the plane of the drawing. The side wall 105 of the trench 101 may include a plurality of sidewall sections which extend from the periphery of the base 104 to the first major surface 103. In embodiments in which the trench 101 has an elongate structure, the trench 101 may have a substantially rectangular form in plan view and include four sidewall sections with adjoining sidewall sections extending substantially perpendicularly to one another. In some embodiments, the trench 101 has a continuous ring-shape and includes two continuous side walls 105 which may extend substantially parallel to one another to form the ring-shape. The ring-shape may be circular, square or have a polygonal form in plan view.

In some embodiments, the trench 101 may have a columnar or needle-shape in top view. A columnar or needle-shaped trench has a small or narrow circumference or width in proportion to its height / depth in the substrate. For example, the depth is at least twice the width. A columnar or needle trench may have an octagonal, circular, square, or hexagonal shape in plan view. The columnar trenches may be arranged in a regular square grid array of rows and columns, or an offset rows or a hexagonal array, for example. In embodiments in which the first trench is columnar or needle-shaped, the first trench has a single side wall if it is circular in plan view, and is divided into four side wall sections arranged substantially perpendicularly to one another if it is square in plan view, six side wall sections if it is hexagonal in plan view etc.

The trench 101 has a width W which is defined by the semiconductor material forming the side wall 105. For example, for an elongate trench 101, the width W is the width between opposing side wall sections, e.g. the distance between the two parallel longest side wall sections 105a, 105b. For a laterally circular trench 101, the width W is the diameter of the trench 101.

The trench 101 comprises electrically insulating material, e.g. a dielectric material such as silicon oxide or silicon nitride. The trench 101 is free of electrically conductive material. A first electrically insulating layer 106 is provided that is located on and lines the base 104 and side wall 105 of the trench 101. An electrically insulating plug 107 is positioned in the trench 101 and extends across the entire width of the trench 101. The insulating plug 107 is in direct contact with the side wall, i.e. with the semiconductor material of the substrate 102 that forms the side wall 105.

In some embodiments, the electrically insulating plug 107 is in direct contact with the entire perimeter of the side wall 105. In some embodiments, the electrically insulating plug 107 extends across the entire area of the trench 101.

The electrically insulating plug 107 has a lower surface 108 which forms an interface 109 with the first electrically insulating layer 106 and has an upper surface 110 that opposes the lower surface 109. Figures 1A to 1C illustrates three structures for the electrically insulating material.

In some embodiments, for example as illustrated in figure 1A, the upper surface 110 of the plug 107 is coplanar with the first major surface 103 of the semiconductor substrate 102. In other embodiments, the upper surface 110 is positioned within the trench 101 such that it is spaced apart from the first major surface 103, i.e. recessed within the semiconductor substrate 102, by distance.

The electrically insulating plug 107 is in direct contact with the sidewall 105 of the trench 101 in the upper portion 111 of the trench 101. The interface 109 is formed between the lower surface 108 of the plug 107 and the upper surface 114 of the first electrically insulating layer 106. In some embodiments, the first electrically insulating layer 106 fills the lower portion 112 of the trench 101.

The first electrically insulating layer 106 can be considered to be a liner layer which has an outer surface 113 which faces away from the sidewall 105 and base 104 of the trench 101 towards the center of the trench 101. In the embodiment illustrated in figure 1A, the first insulating layer 106 has a thickness such that the outer surface 113 of the first electrically insulating layer 106 positioned on a first sidewall section 105a abuts and contacts and the outer surface 113 of the first electrically insulating layer 106 that is located on a second sidewall section 105b. The second side wall section 105b may oppose the first sidewall section 105a. The contact between the surfaces 113 of the portions of the first electrically insulating layer 106 positioned on the opposing sections 105a, 105b of the sidewall of the trench 101 forms an interface 115. This interface 115 may also be called a seam.

In some embodiments, for example as illustrated in figure 1A, the contact is continuous throughout the height of the interface 115.. This arrangement of the first electrically insulating layer 106 may be produced by forming the first electrically insulating layer 106 by a thermal growth method, for example by oxidation of a silicon substrate by applying heat, such that the thickness of the first insulating layer 106 is increased by growth of the layer towards the center of the trench 101. The trench 101 may also have a tapered form with a larger width at the top, i.e. the open end, than the width at the base of the trench 101. The interface 115 may be located at the center of the trench 101 and extend substantially parallel to the side wall 105 and substantially perpendicularly to the base 104 of the trench 101

The electrically insulating plug 107 is formed separately from the first electrically insulating layer 106 and may be a deposited layer. For example, the plug 107 may be deposited using a high density plasma process or a TEOS (Tetra Ethyl Ortho Silicate) process. Since the plug 107 is formed subsequently to the first electrically insulating layer 106, an interface 109 is formed between the lower surface 108 of the plug 106 and the upper surface 114 of the first electrically insulating layer 106. The plug 107 may have a higher density than the first electrically insulating layer.

In an embodiment, both the first electrically insulating layer 106 and the plug 107 are formed of silicon oxide but fabricated using different processes, e.g. thermal growth of silicon oxide at the surface of the silicon substrate 100 to form the electrically insulating layer 106 and high density plasma deposition of silicon oxide, to form the plug 107. In some embodiments, the first electrically insulating layer 106 may comprise two or more sublayers. For example, the first electrically insulating layer may comprise a first sublayer which is formed on the side walls 105 and base 104 by thermal growth of the silicon surface to from silicon oxide and a second sublayer that is deposited onto the first sublayer to form a stack. The second sublayer may also comprise silicon oxide and be formed by TEOS deposition for example. The plug 107 may be deposited onto the two sublayers by high density plasma deposition of silicon oxide.

In an embodiment, the first electrically insulating layer 106 and the plug 107 are formed of different materials. The first electrically insulating layer 106 may be formed of an oxide, e.g.. silicon oxide and the electrically insulating plug 107 may be formed of a nitride, e.g. silicon nitride. The electrically insulating layer 106 and the electrically insulating plug 107 may be fabricated using different processes, e.g. thermal growth of silicon oxide at the surface of the silicon substrate 100 and high density plasma deposition of silicon nitride, respectively.

The electrically insulating plug 107 is arranged in the upper portion 112 of the trench 101 above the interface 115 formed between the abutting outer surfaces 113 of two portions of the first electrically insulating liner layer 106 and may be used as an additional seal to prevent material, from penetrating into the trench 101 along this interface 115 between the abutting surfaces. During the subsequent processing of the semiconductor substrate 100, the substate 100 may be brought into contact with liquids, for example, during wet chemical processes, such as a wet etch processes, or during photolithographic processes, for example photoresist. The plug 107 may serve to hinder or even prevent these materials from entering the trench 101 and penetrating the interface 115 formed between the abutting surfaces 113 and any gap remaining between the surfaces 113. In some embodiments, the lower surface 108 of the electrically insulating plug 107 may be in direct contact with the interface 115.

Figure 1B illustrates a cross-sectional view of a trench 101 comprising electrically insulating material having a structure according to another embodiment. Similar to the embodiment illustrated in figure 1A, the trench 101 comprises a first electrically insulating layer 106 which lines the sidewalls 105 and the base 104 of the trench 101 and also includes an electrically insulating plug 107 which is positioned within the trench 101, extends across the entire width W of the trench 101 and which has a lower surface 108 forming an interface 109 with an upper surface 114 of the electrically insulating layer 106. In this embodiment, a small gap or cavity 116 is formed in the center of the trench 101 between the outer surface 113 of the first electrically insulating layer 106 positioned on the two opposing sidewall sections 105a, 105b. In some embodiments, for example as illustrated in figure 1B, the gap 116 may form an enclosed cavity which is surrounded on all sides by the first electrically insulating layer 106. For example, the surfaces 113 may abut to form an interface 115 below and above the cavity. In other embodiments, for example as illustrated in figure 1C, the gap 116 may be open at the top and covered by the electrically insulating plug 107 so as to form an enclosed sealed cavity or void 117 within the trench 101.

The first electrically insulating layer 106 including the interface 115 and gap 116 is positioned in the lower portion 112 of the trench and the electrically insulating plug 107 is positioned vertically adjacent the first major surface 103 in the upper portion 111 of the trench 101. In some embodiments, e.g. as illustrated in figure 1B, the upper surface 110 of the plug 107 is positioned within the trench 101 and is positioned within the semiconductor substrate 102 and spaced apart from the first major surface 103. In another embodiment, the upper surface 110 is coplanar with the first major surface 103. In some embodiments, the plug 107 is in direct contact with the material of the sidewall 105 of the trench 101 in regions vertically adjacent to the first major surface 103 and extends across the entire width and, in some embodiments, the entire lateral area, of the trench 101 so as to plug or seal the trench 101.

In some embodiments, a thin native oxide is present on the side wall 105 and the plug 107 is in direct contact with this native oxide. In some embodiments, a thin thermal silicon oxide layer is present on the side wall 105 and the plug 107 is in direct contact with this thin thermal silicon oxide layer and the trench 101 is free of electrically conductive material.

Figure 1C illustrates a cross-sectional view of a semiconductor device 100 including a trench 101 having an electrically insulating structure according to an embodiment. The trench 101 includes a first electrically insulating layer 106 which is positioned on the base 104 and sidewalls 105 in the lower portion of the trench 106 and an electrically insulating plug 107 which is positioned at in the upper portion of the trench 101 and which fills the entire width W of the trench 101 in the upper portion 112. In this embodiment, the first electrically insulating layer 106 has a thickness such that a gap 116 formed between the surfaces 113 of the electrically insulating layer 106 formed on the base 104 and sidewall 105. This gap 116 is sealed at the top by the plug 107. The plug 107 is in contact with side wall 105a of the trench 101. The lower surface 108 of the plug 107 forms an interface 109 with the portion of the first electrically insulating layer 106 formed on the sidewall 105a, extends over the gap 116, forms an interface 109 with the portion of the electrically insulating layer 106 formed on the sidewall 105b and is in contact with the side wall 105b so as to form a sealed cavity or void 117 within the trench 101.The plug 107 contacts the entire perimeter of the side wall 105 so as to seal the top of the trench 101 and the void 117.

Also illustrated in figure 1C is a third electrically insulating layer 118 which is positioned on the first major surface 103 and which extends over and may be in direct contact with the upper surface 110 of the plug 107. The third electrically insulating layer 118 may be a passivation layer and may/or may be an interlayer dielectric which forms part of a non-illustrated metallization structure formed on the first major surface 103 of the semiconductor substrate 102 and which insulates the metallic layers of the metallization structure from the semiconductor substrate 102.

The third electrically insulating layer 118 and metallization structure may also be located on the first major surface 103 of the semiconductor substrate 102 and on the upper surface 110 of the plug 107 of the trench 101 having the structure illustrated in figures 1A and 1B.

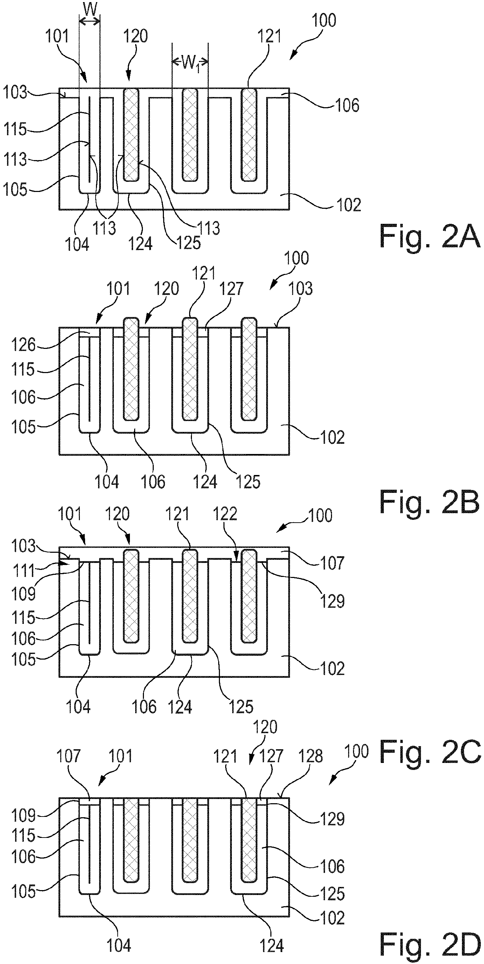

A method for fabricating a trench comprising electrically insulating material will now be described with reference to figure 2, which includes figures 2A to 2D. This method may be used to fabricate the trench according to any one of the embodiments described herein including the trench 101 described with reference to figures 1A to 1C.

Figure 2A illustrates a cross-sectional view of a portion of a semiconductor device 100 which includes a trench 101 formed in semiconductor substrate 102. The trench 101 includes a base 104 and at least one sidewall 105 which extends from the base 104 to the first major surface 103 of the semiconductor substrate 102. The trench 101 has a width W. Also shown in figure 2 are three further trenches 120 each of which includes an electrically conductive field plate 121. The further trenches 102 include a base 124 and a side wall 125 which extends from the base 124 to the first major surface 103 and a width W₁ which is greater than the width W of the trench 101.

A first electrically insulating layer 106 is formed which lines the trench 101 and the further trenches 120 and which is also located on the first major surface 103. In some embodiments, the first electrically insulating layer is formed by thermal growth, e.g. by oxidation of the free lying surfaces of the semiconductor substrate 102 so as to form an oxide lining that covers the base 104 and side wall 105 of the trench 101, the base 124 and side wall 125 of the trenches 120 and the first major surface 103. The semiconductor subject 102 may be formed of silicon, for example monocrystalline silicon or epitaxial silicon and the first electrically insulating layer 106 is formed of silicon oxide SiOₓ. In some embodiments, the first electrically insulating layer comprises two sublayers. A first sublayer may be formed by thermal growth and a second sublayer deposited on the first sublayer. The second sublayer may be formed by a TEOS process.

The electrically insulating layer 106, which lines the base 104 and sidewall 105 of the trench 101, has a thickness such that the outer surface 113 of the layer 106 on a first sidewall section 105a abuts and contacts the outer surface 113 of a portion of the first electrically insulating layer 106 arranged on a further sidewall portion, e.g. the opposing side wall section 105b or the base 104 of the trench 101. The trench 101 is substantially filled with the electrically insulating material 106 and an interface 115 is formed between the two abutting surfaces 113 of the first electrically insulating liner layer 106.

The trench 101 may have different dimensions to the trenches 120. For example, the trench 101 may have a smaller width than the trenches 120. Thus, after formation of the thermally grown electrically insulating layer 106, the trench 101 is filled with the electrically insulating layer 106 and a gap remains towards the center of the wider trenches 120. Conductive material is inserted into this gap to form the field plate 121. The field plates 121 may be formed of polysilicon, for example. The field plate 121 formed in each of the trenches 120 is electrically insulated from the semiconductor substrate 102 by the electrically insulating layer 106 which is positioned on the base 124 and sidewalls 125 of the trench 120.

Referring to figure 2B, portions of the thermally grown first electrically insulating layer 106 that are arranged on the first major surface 103 and in the upper portion 111 of the trench 101 and in the upper portion 122 of the trenches 120 is removed so that a recess 126 is formed in the upper portion 111 of the trench 101 which has a base formed by the first electrically insulating layer 106. At the same time, the electrically insulating layer 106 is also removed from the trenches 120 around the field plates 121 to form a ring-shaped recess 127 that surrounds the field plate 121 in the upper portion 122 of the trench 120. The portions of the thermally grown first electrically insulating layer 106 may be removed by plasma etching, for example. The uppermost portion of the sidewall 105 of the trench 101 and of the sidewall 125 of the trench 120 is exposed from the thermally grown first electrically insulating layer 106. The field plates 121 protrude above the first major surface 103 and are also exposed from the electrically insulating layer 106 in the upper portion 122 of the trench 120.

Referring to figure 2C, a second electrically insulating layer 107 is formed on the first major surface 103 of the semiconductor substrate 102 which also fills the recess 126 formed in the trench 101 and the recess 127 formed in the trenches 120 and which also covers the field plate 121. The second electrically insulating layer 107 may be a deposited layer and may be formed by high density plasma deposition of an electrically insulating material, for example silicon oxide. The second electrically insulating layer 107 forms an interface 109 with the first electrically insulating layer 106 located in the lower portion of the trench 101 and is in direct contact with the semiconductor material forming the sidewall 105 of the trench 101. The second electrically insulating layer also forms an interface 129 with the first electrically insulating layer 106 positioned in the trenches 120 and is in direct contact with the sidewall 125 of the trenches 120. The second electrically insulating layer 107 is also in direct contact with the first major surface 103 of the semiconductor substrate 102.

Referring to figure 2D, subsequently, a planarisation process is carried out, for example, using chemical mechanical polishing, to form a planarised surface 128 comprising the material of the second electrically insulating layer 107 positioned at the top of each of the trenches 101 and 120, the exposed surface of the semiconductor substrate 102 and the exposed surface of the field plate 120. The second electrically insulating layer 107 now forms a plug 107 in the upper portion of the trench 101 which extends over the entire width W of the trench 101 and which prevents material from entering the trench 101 along the interface 115 formed between the abutting surfaces 113 of the first electrically insulating liner layer 106. In some embodiments, the second electrically insulating layer 107 also forms a cover 127 positioned within the trenches 120 on top of the thermally grown first electrically insulating layer 106 and surrounds the side walls of the field plate 121 at the top of the trench 120. The cover 127 may have a ring-shape and be in direct contact with the side wall 125 of the trench 120 and with the side face of the field plate 121.

The plug 107 and cover 127 hinders material from entering the trenches 101, 120, in particular penetrating into the trench 101 along the abutting surfaces 113 of the interface 115 and into any gap formed between the surfaces 113 of the first electrically insulating layer 106.

The depth of the recess 126 formed in the trench 101 and the depth of the recess 127 formed in the trenches 120 may be selected such that after the planarisation process, the plug 107 and the cover 127 is formed in the trenches 101, 120, respectively. The height of the plug 107 and the cover 127 may be the same or may be different. In other words, the depth of the recesses 126, 127 may be the same or different. In other embodiments, during the planarisation process the second electrically insulating layer 107 is removed from the first major surface 103 of the semiconductor substrate 102 such that the plug 107 is formed in the trench 101, the cover 127 in the trenches 120 and the first major surface 103 of the semiconductor substrate 102 is exposed in the planarised surface 128.

The method described with reference to figure 2 may be carried out solely to fabricate the trench 101. In other embodiments, the method may be integrated into the process for fabricating a device in an active area of the semiconductor substrate, e.g. a transistor device having the field plates 121 in the trenches 120 and/or into the process for fabricating an edge termination structure. The trench 101 may, for example, be used in an edge termination structure, e.g. as a continuous trench that laterally surrounds the active area, and the trenches 120 may form part of the active transistor cells of a transistor device.

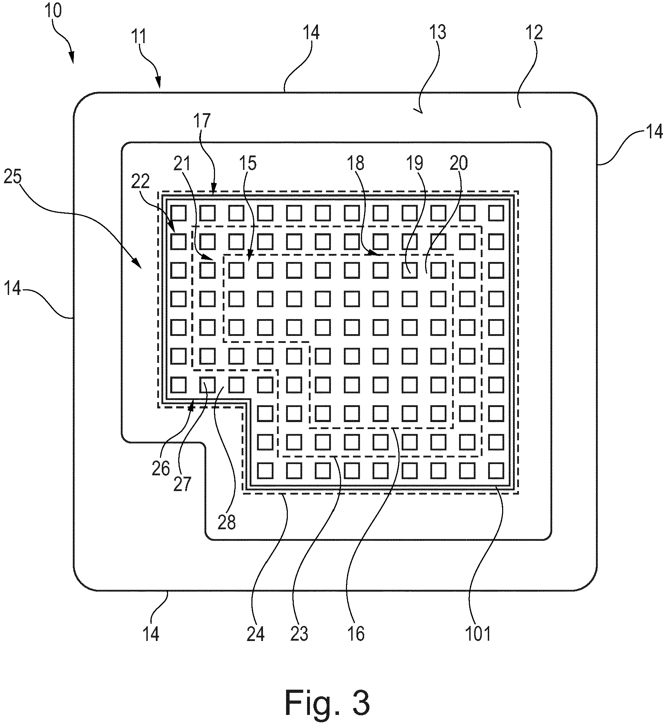

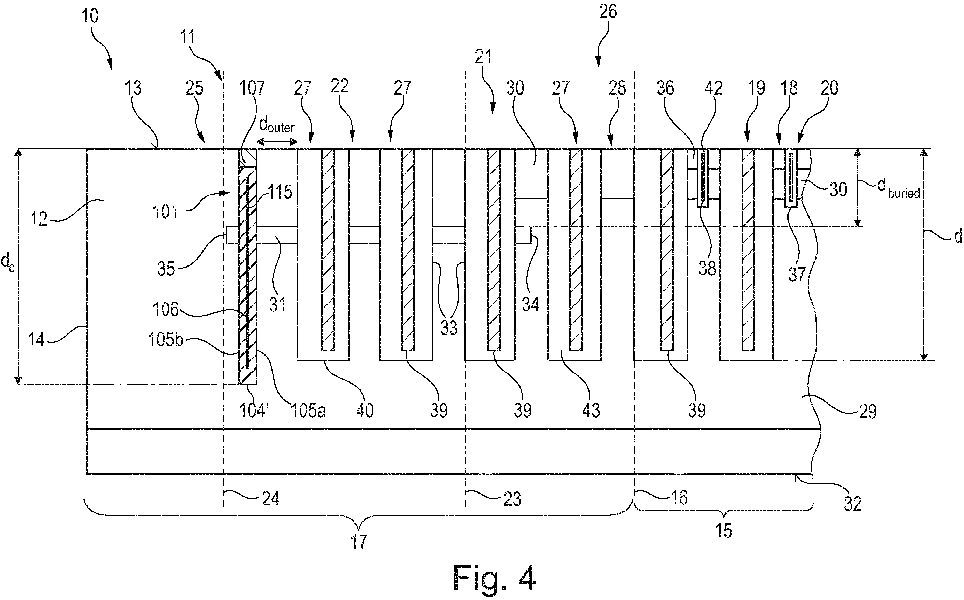

Figure 3 illustrates a top view of a semiconductor device 10 which includes a transistor device 11 and at least one trench 101 having the structure according to any one of the embodiments described herein. Figure 4 illustrates a cross-sectional view of a portion of the semiconductor device 10 of figure 3.

The transistor device 11 may be a vertical field effect transistor device based on a charge compensation principle. The semiconductor device 10 includes a semiconductor body 12 having a first surface 13, a second surface 32, which cannot be seen in the top view of figure 3, that opposes the first surface, and side faces 14 extending between the first surface 13 and the second surface 32. The semiconductor body 12 may comprise silicon and may include a silicon epitaxial layer deposited on a substrate such as a single crystal silicon substrate. The first surface 12 can be referred to as the top surface and the second surface as the rear surface.

The semiconductor device 10 includes an active area 15 which is denoted by the dashed line 16 in the plan view of figure 3. The active area 15 is laterally surrounded by an edge termination region 17. The edge termination region 17 laterally surrounds the active area 15 on all sides. The edge termination region 17 includes an edge termination structure for avoiding breakdown of the semiconductor device 10 at or near the first surface 13 and for increasing the breakdown voltage of the semiconductor device 10. The edge termination structure may, for example, lower the field intensity junction by spreading the electric field lines across the edge termination region 17.

The active area 15 includes a plurality of active transistor cells 18. Each active transistor cell 18 comprises a columnar trench 19 which comprises a field plate 39 and a mesa 20. The mesas 20 are formed by the regions of the semiconductor body 12 that are located between the columnar trenches 19. The mesas 20 include a drift region 29 of the first conductivity type.

The columnar trenches 19 may be arranged in an array, such as a regular array, such as a regular grid, for example rows and columns, or may be arranged in an array of staggered or shifted rows, in which the columnar trenches 19 of each row have the same pitch or spacing in the long direction of the row and are offset in the long direction with respect to an immediately adjacent row of the array. In some embodiments, the columnar trenches 19 are arranged in an array in which the columnar trenches have a regular pattern such as a hexagonal place packed arrangement. The lateral form of each of the columnar trenches 19 within the array having any form or pattern may be square, octagonal, round or hexagonal, for example. For example, the columnar trenches may have a lateral octagonal form in plan view and be arranged in staggered rows.

The edge termination region 17 comprises a transition region 21 which laterally surrounds the active region 15 and an outer termination region 22 which laterally surrounds the transition region 21 and an outer region 25 that laterally surrounds the outer termination region 22. The boundary between the transition region 21 and the outer termination region 22 is indicated by the dashed line 23 and the boundary between the outer termination region 22 and the outer region 25 is indicated by the dashed line 24 in figures 3 and 4.

The transistor device 11 may be a vertical MOSFET device that comprises a field plate 39 for charge compensation. The source and gate of the MOSFET device are positioned at the first surface 13 and the drain is positioned at the second opposing surface so that the drift path of the MOSFET device extends vertically and substantially perpendicular to the first surface 13 and the second surface 32. MOSFET devices with a field plate for charge compensation offer an improvement of the area-specific resistance. Some of these devices use a stripe design, i.e. the trenches and the mesas have an elongate strip form and are arranged alternatively so that a strip-like mesa is defined by two adjacent strip-like trenches. However, some types of designs of MOSFET devices with a field plate for charge compensation, such as those described herein, include columnar or needlelike trenches 19 so that the mesa 20 is formed by the material between the columnar trenches 19.

A columnar field plate 39 is positioned in the columnar trenches 19 and is electrically insulated from the semiconductor body 12 by a dielectric material 43 that lines the sidewalls 33 and base 40 of the columnar trench 19. The columnar trench 19 is typically a deep trench containing the field-plate 39 in the center. A separate shallower gate trench 37 is positioned in the mesa 20. The gate electrode 38 of the transistor cell 18 is positioned in the gate trench 37. The gate trench 37 has an elongate form. This design results in a larger cross section of the mesa region 20 which is expected to lead to a further reduction of the overall on-resistance.

In some embodiments, the gate trenches 37 have a strip-like form and extend substantially parallel to one another. One gate trench 37 is positioned adjacent two opposing sides of the columnar trench 19. In some embodiments, the gate trenches 37 interconnect to form a grid structure that laterally surrounds each columnar trench 19.

The transition region 21 and the outer transition region 22 of the edge termination region 17 comprise a plurality of inactive cells 26. Each inactive cell 26 comprises a columnar termination trench 27 and a termination mesa 28. The columnar termination trench 27 also comprises a field plate 39. The termination mesa 28 includes a drift region of a first conductivity type.

The edge termination region 17 further includes at least one trench 101 that is positioned in the outer termination region 22 and that continuously laterally surrounds the active area 15 and the columnar termination trenches 27. The trench 101 may have the structure described with reference to any one of figures 1A to 1C.

The continuous trench 101 continuously and uninterruptedly laterally surrounds the columnar termination trenches 27 and the inactive cells 26. The columnar termination trenches 27 and the columnar trenches 19 of the active cells 18 may be arranged in an array, for example a grid of rows and columns. The continuous trench 101 laterally surrounds and is arranged at the periphery of this array, i.e. between the array of columnar edge termination trenches 27 and the side faces 14 of the semiconductor body 12. The continuous trench 101 is free of electrically conductive material and does not include a field plate.

In some embodiments, the continuous trench 101 is spaced apart from a laterally outermost one of the columnar termination trenches 27 by a distance dₒᵤₜₑᵣ. dₒᵤₜₑᵣ may be 101 nm ≤ dₒᵤₜₑᵣ ≤ 2 µm. The semiconductor body 12 typically has a cuboid form with substantially perpendicular substantially straight side faces 24 that intersect at corners. The distance dₒᵤₜₑᵣ is measured adjacent to the side faces 24 rather than at the corners.

In some embodiments, the lateral shape, pattern and pitch (centre-to-centre spacing) of the columnar termination trenches 27 may be the same as that for the columnar trenches 19 of the active transistor cells 17 of the active area 15. The field plates in the columnar termination trenches 27 and in the columnar trenches 19 may be of the same size and shape.

In some embodiments, some or all of the termination mesas 28 are laterally smaller than the mesas 20 in the active region 15. This smaller width of the termination mesas 28 may be the result of the columnar termination trenches 27 having the same centre-to centre spacing or pitch, but each columnar termination trenches 27 being laterally wider than the columnar trenches 19 in the active region 15.

However, in other embodiments, some or all of the termination mesas 28 are laterally wider than the mesas 20 in the active region 15.

In some embodiments, the termination mesas 28 and columnar termination trenches 27 which are positioned laterally nearer to the active region 15 have the same width as the mesas 20 and columnar trenches 19, respectively, in the active area 15, whereas the termination mesas 28 which are positioned laterally more outwardly from the active area 15 are laterally smaller, e.g. narrower, than the mesas 20 in the active area 15 and the columnar termination trenches 27 which are positioned laterally more outwardly from the active area 15 have a greater lateral size, e.g. width, than the columnar trenches 19 in the active area 15.

In some embodiments, the doping level of the drift region 29 in the narrower termination mesas 28 is higher than the doping level of the drift region 29 in the mesas 20 in the active area 15 and in the wider termination mesas 28.

In some embodiments, the columnar termination trenches 27 and the columnar trenches 19 in the active region 15 have the same depth, i.e. have a base or bottom that is positioned at approximately the same distance from the first surface 13. In other embodiments, the columnar termination trenches 27 in the transition region 21 and outer transition region 22 have a greater depth than the columnar trenches 19 in the active region 15.

Figures 4 illustrates a cross-sectional view of a portion of the semiconductor device 10 and illustrates a portion of the active area 15 and the edge termination region 17 including the transition region 21, the termination region 22 and the outer region 25.

In the active area 15, the mesas 20 comprise the drift region 29 of a first conductivity type, a body region 30 of a second conductive type that opposes the first conductivity type that is arranged on the drift region 30 and a source region 36 of the first conductive type that is arranged on the body region 30 and that extends to the first surface 13. The source region 36 is more highly doped that the drift region 29. For example, in some embodiments, the first conductivity type is n-type and the second conductivity type is p-type or vice versa.

In the transition region 21, the termination mesa 28 comprises a body region 30 of the second conductivity type that is arranged on the drift region 29. In the transition region 21, the body region 30 extends to the first surface 13 of the semiconductor body 12 so that no source region is provided. These cells are, therefore, inactive.

In the outer termination region 22, the drift region 29 of the termination mesas 28 extends to the first surface 13 of the semiconductor body 12. The termination mesas 28 in the outer termination region 22, in contrast to the termination mesas 28 in the transition region 21, do not include a body region.

The transition region 21 is distinguishable from the outer termination region 22 by the presence of the body region 30. The region of the semiconductor body 12 that is doped with the first conductivity type and provides the source region 36 is laterally smaller than the region of the semiconductor body that is doped with the second conductivity type and that forms the body region 30. The lateral extent of the body region 30, as defined by the outer edge of the body region 30, is less than the lateral extent of the drift region 29 and the first surface 13.

The outer termination region 25 that surrounds and, in particular, is contiguous with the outer termination region 22 is free of inactive cells. Therefore, the outer termination region 25 is free of columnar trenches and mesas. The outer termination region 25 may include semiconductor material of the first conductivity type.

The mesas 20 of the active cells 18, the termination mesas 28 of the inactive cells 26 of the transition region 21 and of outer termination region 22 of the edge termination region 17 include the drift region 29 comprising a first conductivity type. The drift region 29 and the outer termination region 25 may be formed from an epitaxial silicon layer.

The at least one continuous trench 101 is positioned in the outer termination region 22 and laterally surrounds the array of columnar termination trenches 27. The continuous trench 101 is filled with at least one dielectric material. In contrast to the columnar termination trenches 27, the continuous trench 101 is free of electrically conductive material and, therefore, free of a field plate. The continuous trench 101 has side walls 105a, 105b and a base 104 that is positioned at a depth d_{c} from the first major surface 13. The depth d_{c} may be substantially the same as the depth d of the columnar trenches 19, 27 or may be less than or greater than the depth d. The depth d_{c} of the continuous trench 101 is, however, greater than the depth d_{g} of the gate trench 37.

The trench 101 comprises the first electrically insulating layer 106 that lines the base 104 and side wall 105 and that has a thickness such that the outer surfaces 113 abut one another to form an interface 115. The trench 101 further comprises the electrically insulating plug 107 that forms an interface 109 with the first electrically insulating layer 106 and that is in direct contact with the side wall 105 of the trench 101 such that the entire area of the trench 101 is sealed by the plug 107. The trench 101 may have the structure described with reference to any one of figures 1A to 1C and may be fabricated using the method described with reference to figure 2. For example, the first electrically insulating layer 106 may be a thermally grown SiOₓ layer and the plug 107 may comprise SiOₓ and be formed by high density plasma deposition. The plug 107 may have a higher density than the first electrically insulating layer 106.

The dielectric material of the first electrically insulating layer 106 and the plug 107 positioned in the continuous trench 101 has a dielectric constant εr which is lower than the dielectric constant of silicon which has εr of 11.7. Possible dielectric materials for the continuous trench 101 include SiO₂ with εr around 3.9 and/or a vacuum with εr of 1.0.

In some embodiments, such as that illustrated in figure 4, the edge termination region 17 further comprises a buried doped region 31 which can be seen in the cross-sectional view of figure 2. The buried doped region 31 has a lateral extent such that it is positioned in both the transition region 21 and in the outer termination 22 of the edge termination region 17. The buried doped region 31 comprises the second conductivity type. The continuous trench 101 extends through the buried doped region 31. The buried doped region 31 extends between the sidewalls 33 of at least some of the columnar termination trenches 27 and the continuous trench 101. The buried doped region 31 forms a portion of the sidewalls 33 of at least some of the columnar termination trenches 27 and a portion of the two opposing elongate side walls 105a, 105b of the continuous trench 101.

The buried doped region 31 is positioned within the semiconductor body 12 at a distance from the first major surface 13 and has the form of a single doped region. The buried doped region 31 may have a substantially uniform thickness. The buried doped layer 31 may have the form of a plate-like layer that is bounded above and below by portions of the drift region 29 and that is spaced apart from the first major surface 13 and from the second major surface. This plate-like buried doped layer may also have a uniform thickness. In some embodiments, the buried doped layer 31 may be spaced apart from the body region 30 by a portion of the drift region 29.

In some embodiments, a portion of the buried doped layer 31 is spaced apart from the body region 30 by a portion of the drift region 29 and vertically overlaps a portion of the body region 30.

The buried doped layer 31 is doped with the second conductivity type, e.g. p-type, whereas the drift region 29 is doped with the first conductivity type, e.g. n-type. The buried doped layer 31 can be considered to provide a counter doping layer. In some embodiments, the doped buried layer has a doping concentration of 1e14-1e17/cm³ which may be produced from an implant of 1e11 - 1e13/cm² and the drift region a doping concentration of 1e14-1e17/cm³.

The lateral extent of the buried doped layer 31 may be defined by an inner edge 34 and an outer edge 35. In some embodiments, the buried doped region 31 comprises an inner edge 34 that is positioned in the transition region 21 of the edge termination region 17 and is positioned under the body region 30 of the termination mesa 28. The buried doped region 31 is vertically spaced apart from the body region 30 of the termination mesa 28 by a portion of the drift region 29. In some embodiments, the inner edge of the buried doped region 31 may be arranged such that the buried doped region 31 is positioned underneath the body region 30 that is positioned in two or more neighbouring termination mesas 28.

In at least some of the transition region 21, the body region 30 does not vertically overlap with the buried doped region 31. In particular, the portion of the body region 30 that is laterally positioned nearer to the active area 15 does not vertically overlap with the buried doped region 31. The inner edge 34 of the buried doped region 21 is laterally spaced apart from the active area 15 by at least one inactive cell 26 including a columnar termination trench 27 and termination mesa 28. In some embodiments, one or more termination mesas 28, which are laterally contiguous to the active region 15, have a structure such that the drift region 29 extends without interruption to the body region 30 and are free of the buried doped region 31.

In some embodiments, the buried doped region 31 has an outer edge 35 that is positioned in the outer region 25 of the edge termination region 17 so that the buried doped region 31 extends from within the transition region 21, over the entire width of the intermediately situated outer termination region 22 and into the outer region 25 which is free of inactive cells. The outer edge 35 of the buried doped region 31 is positioned laterally between the side face 14 of the semiconductor body 12 and the continuous trench 101. Thus, the continuous trench 101 extends through and interrupts the doped buried layer 31 such that the doped buried layer 101 forms a portion of the opposing side walls 105a, 105b of the continuous trench 101.

The buried doped region 31 forms a portion of the sidewalls of at least two laterally adjacent rows of columnar termination 27 trenches, whereby one row is positioned in the transition region 21 and the other row is positioned in the outer termination region 22, since the buried doped region 31 has a lateral extent such that it is positioned in both the transition region 21 and in the outer termination region 22 of the edge termination region 17.

The columnar trenches 17 arranged in the active area 15 and the columnar termination trenches 27 arranged in the edge termination region 17 extend from the first surface 13 into the semiconductor body 12 by a distance d such that the columnar trenches 17, 27 have a base or bottom positioned at a depth d from the first surface 13. The buried doped region 31 is, in some embodiments, positioned at a depth d_{buried} from the first surface, wherein 0.6 µm ≤ d_{buried} ≤ 2.0 µm. d_{buried} < d, the depth of the base 40 of the columnar trenches 19, 27 from the first major surface 13. Additionally, d_{buried} < d_{c}, the depth of the base 104 of the continuous trench 101 from the first major surface 13.

The buried doped region 31 may have the form of a continuous ring when viewed from above that is positioned laterally adjacent all sides of the active area 15 and continuously laterally surrounds the active area 15.

The doped buried region 31 may have the form of a layer having substantially uniform thickness. In some embodiments, the upper boundary of the buried doped region 31 is positioned at a depth d_{1buried} from the first surface and the lower boundary of the buried doped region 31 is positioned at a depth d_{2buried} from the first surface, whereby d_{2buried} > d_{1buried} and (d_{1buried} - d_{2buried}) is around 200nm to 800nm.

The buried doped region 31 may be used in order to counterdope the mesa epi and to realize a reduced area-specific on-resistance. In some embodiments, the buried doped region 31 extends in the area of the edge termination trenches 28 of the edge termination region 17 and from within the transition region 21, through the outer termination region 22 and into the outer region 25. The buried doped region 31 counterdopes the epitaxy of the opposition conductivity type in the termination region so that the combination behaves like high resistivity epitaxial layer. This means that the heavily doped epitaxial layer used in the active area to achieve a low resistance is effectively higher resistance in the termination region making it easier to support a higher voltage.

Extending the buried doped region 31 from the edge needle, i.e. the outermost columnar trench 27 until at least the oxide trench 101 counter dopes the intervening silicon. This allows the oxide trench 101 to be placed much further away from the outermost columnar trench 27. This reduces stress in this silicon region. It also widens the acceptable range of mesa widths improving manufacturing.

In some embodiments, this additional buried doped region 31 has the following combination of properties: it is fully depletable in order to locally relax the electric field, it laterally extends under the outer end of the body region 30 in the transition region 21 in order to avoid an early breakdown at the curvature at the end of the body region 30 and it extends laterally towards the side faces 14 of the semiconductor body 12 into the outer termination region 25, which includes no columnar trenches with field plates, in order to 'stretch' the potential lines at the outer side of the termination structure and to relax the electric field at the laterally outermost trench 27 of the edge termination region 17 so as to avoid an early breakdown at this location.

The combination of the continuous dielectric filled trench 101 and doped buried region 31 in the edge termination region 17 provides an edge termination structure that moves avalanche breakdown into the active cell area greatly improving the avalanche performance. As the edge termination structure is small, a larger active area and, therefore, a better Ron.Area is achieved. The transistor cell structure may be further optimized to achieve better Ron.Area and switching characteristics.

Referring to figure 4, each mesa 20 of the active transistor cells 18 comprises the drift region 29 of the first conductivity type, a body region 30 of the second conductivity type which is arranged on the drift region 29 and a source region 36 of the first conductivity type which is arranged on the body region 30. Each of the columnar trenches 19 of the active transistor cells 18 extends from the first surface 13 through the source region 36 the body region 30 and into the drift region 29.

Each mesa 20 of the active transistor cells 18 also includes a gate trench 37 comprising a gate electrode 38. The gate electrode 38 is electrically insulated from the mesa 20 by an insulating layer 42 which lines the side walls and base of the gate trench 37. The gate trench 37 extends through the source region 36 and the body region 30 to the drift region 29. The depth of the columnar trenches 19 from the first surface 13 is greater than the depth of the gate trench 37 from the first surface 13. The gate trench 37 is elongate having a length extending into the plane of the drawing. The gate trenches 37 may be arranged parallel to one another and be positioned on two opposing sides of the columnar trenches 19 or may interconnect to form a grid structure and be laterally positioned adjacent more than two sides or on all sides of the columnar trench 19.

The columnar trenches 19 of the active transistor cells 18 and the columnar termination trenches 27 of the edge termination region 17 each include a field plate 39 which is positioned towards the bottom of the columnar trench 19, 27, respectively. The field plate 39 is electrically insulated from the semiconductor body by an electrically insulative layer 43 which lines the sidewalls 33 and base 40 of the columnar trenches 19, 27.

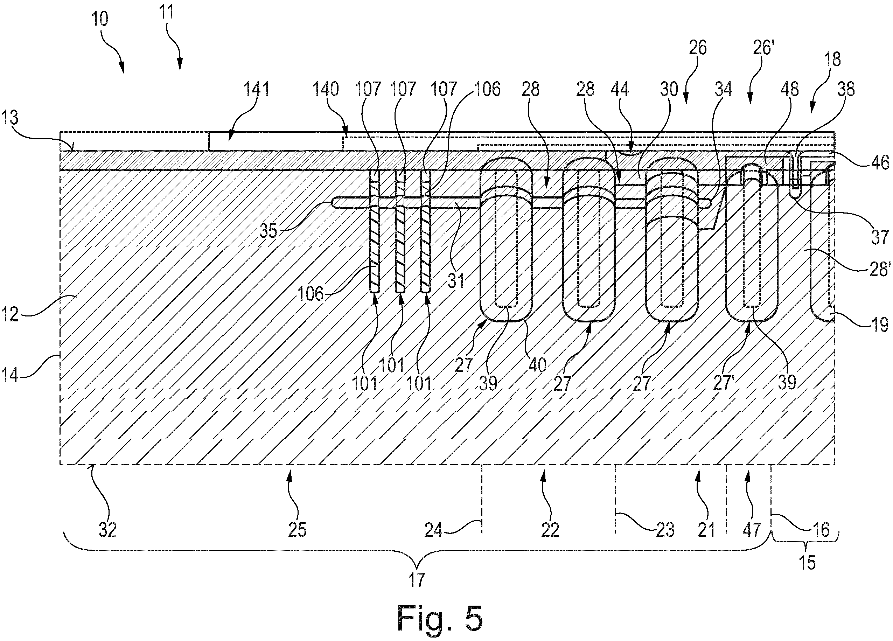

Referring to figure 5, in some embodiments, the edge termination region 17 comprise two or more continuous trenches 101 that are arranged concentrically such that they are spaced apart from one another by a continuous mesa 60. In figure 4, three continuous trenches 101 are shown. In some embodiments, the spacing between the continuous trenches 101, i.e. the width of the continuous mesa 60, may be substantially the same as the spacing dₒᵤₜₑᵣ between the laterally innermost continuous trench 101 and the laterally outermost columnar trench 27 as measured adjacent the side face 14 of the semiconductor body 12.

Referring to figure 5, in some embodiments, the edge termination region 17 further includes an inner transition region 47 that is formed at the boundary between the transition region 21 and the active region 15. This inner transition region 47 includes one or more rows of inactive cells 26' having a columnar termination trench 27' and a termination mesa 28'. The termination mesa 28' and associated columnar termination trench 27' has a body region 30 and does not have a source region so that the body region extends to and forms the first surface 13. The columnar termination trenches 27' in this inner transition region 47 are distinguished from the columnar termination trenches 27 of the transition region 21 by a body contact 48. The body contact 48 positioned in the columnar termination trench 27' is used to electrically couple the body region 30 to source potential.

The various regions of the semiconductor device 10 can be distinguished by the connections to the trenches. In the active area 15, the trenches 19 and associated mesa 20 includes a body region 30, a source region 36 on the body region. In the inner transition region 47, columnar termination trenches 27' and their associated termination mesa 28' have a body region 30, a body contact 48 and no source region. In the transition region 21, the columnar termination trenches 27 and associated termination mesa 28 have a body region 30, no body contact and no source region. In the outer transition region 22, the columnar termination trenches 27 and associated termination mesa 28 have no body region, no body contact and no source region.

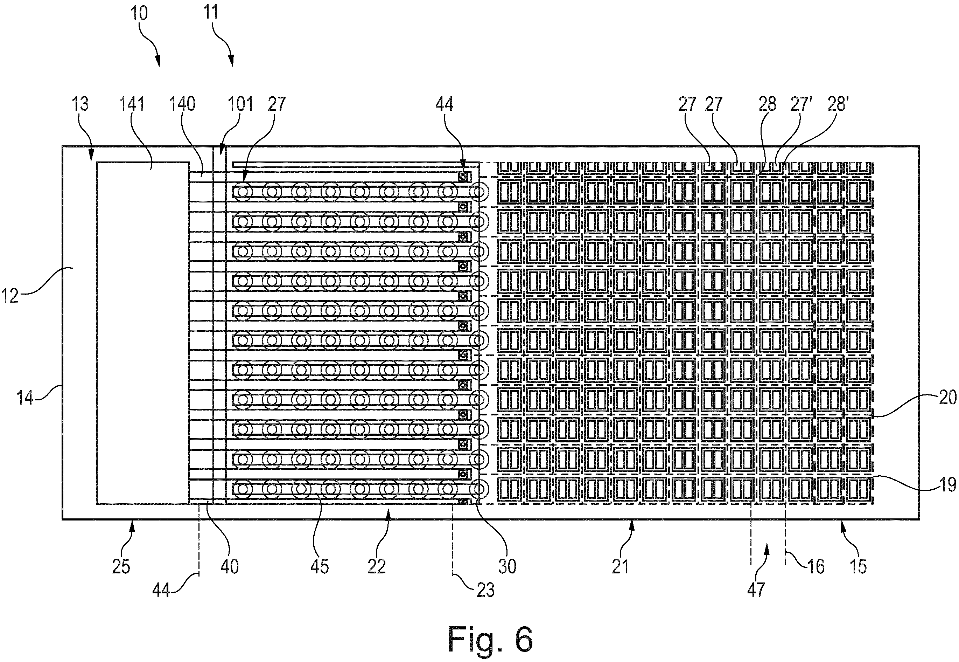

Figure 6 illustrates a top view of a portion of the semiconductor device 10 of figure 4, whereby the position of the continuous trench 101 is shown, and illustrates a portion of the active region 15, the transition region 21, the outer transition region 22 and outer termination region 25. Figure 6 also illustrates the metallisation structures which are electrically connected to the source region 36 of the active transistor cells 18 and the gate electrodes 38 of the active transistor cells 18.

In the plan view of figure 5, eight edge termination trenches 27 are illustrated. However, the design is not limited to eight termination trenches and may include more than or fewer than eight trenches. In practice, fewer than eight trenches are required in order to provide beneficial effects.

Figure 6 illustrates that the semiconductor device 10 further includes a gate runner 141 positioned on the first surface 13 in the outer region 25 of the semiconductor device 10 and at least one gate finger 140. The gate finger 140 and the gate runner 141 may be comprised of metal. The gate runner 141 may be positioned laterally between and spaced apart from the side face 14 of the semiconductor body 12 and the outer edge 35 of the buried doped region 31. The gate runner 141 is positioned between the side face 14 of the semiconductor body 12 and the continuous trench 101 and, in embodiments including two or more continuous trenches, between the side face 14 of the semiconductor body 12 and the laterally outermost one of the continuous trenches 101. The gate fingers 140 extend from the gate runner 141, over the edge termination region 17 to a position within the transition region 21 where it is electrically coupled to the gate electrode 38 by a groove contact 44.

Source fingers 45, which are electrically coupled to the source regions 31 of the active transistor cells 18, are arranged alternately with the gate fingers 140. The gate contact 44, which may have the form of a groove, extends from the gate finger 140 which is electrically coupled to the gate electrodes 38 of active transition transistor cells 17. The gate contact 44 may be positioned above the body region 30 in the transition region 21. One or more insulation layers 46 are arranged on the body region 30 between the body region 30 and the gate finger 140.

The body region 30 of the semiconductor device 10 is arranged to extend from the active area 15 into the transition region 21 of the termination structure 17. This arrangement enables the contact from the gate finger 140 to the gate trench grid to be realized outside of the active area 15. The lateral width of the transition region 21, which is inactive as there is no source is present in the termination mesas 28, can be used to provide a minimum distance between the edge of the source region 36 within the active region 15 and the edge of the overlying source metal layer and a large enough distance to hinder potentially hazardous ion drifts from the metal edge into the active region. As such the width of this transition region 21 between the boundary 23 and 24 is not determined by the blocking capability of the edge termination structure.

The highest potential remains spaced apart from the base of the trenches 19 in the active cells 18 and from the surface near the outermost columnar trench 27' of the edge termination structure.

The depletable additional buried doped region 31 is able to locally relax the electric field. As it laterally extends under the outer end 101 of the body region 30 in the transition region 21, an early breakdown at the curvature at the end 101 of the body region 30 is avoided. As it extends laterally towards the side faces of the semiconductor body 12 into the outer region 25 which includes no columnar trenches with field plates, the potential is laterally stretched at the outer side of the termination structure and reduced at the laterally outermost trench 27' of the edge termination region so as to avoid an early breakdown at this location in particular at the surface of the semiconductor body 12 at the laterally outermost trench 27' of the edge termination region 17.

A breakdown location in the inactive transistor cells which are without a body contact are avoided, thus demonstrating that the edge termination structure including the buried doped layer 31 as described herein has the desired effect of avoiding breakdown at the surface in the edge termination region.

Although the present disclosure is not so limited, the following numbered examples demonstrate one or more aspects of the disclosure.

### Examples

Example 1. A semiconductor device, comprising:
a semiconductor substrate having a first major surface;
a trench positioned in the semiconductor substrate and having a width, a base and a side wall extending from the base to the first major surface;
a first electrically insulating layer that lines the base and side wall of the trench;
an electrically insulating plug that is positioned in the trench and that extends across the entire width of the trench;
wherein the plug has a lower surface that forms an interface with the first electrically insulating layer and an upper surface that is coplanar with the first major surface of the semiconductor substrate or that is positioned within the trench.

Example 2. A semiconductor device according to example 1, wherein the plug is in direct contact with the side wall of the trench.

Example 3. A semiconductor device according to example 1 or example 2, wherein the first electrically insulating layer has a surface and a thickness such that the surface of the first electrically insulating layer located on a first sidewall section abuts the surface of the first electrically insulating layer located on a second side wall section that opposes the first side wall section.

Example 4. A semiconductor device according to example 1 or example 2, wherein the first electrically insulating layer and the electrically insulating plug surround a sealed cavity within the trench.

Example 5. A semiconductor device according to any one of examples 1 to 4, wherein the first electrically insulating layer and the electrically insulating plug are each formed of an oxide, or wherein the first electrically insulating layer comprises an oxide and the electrically insulating layer comprises a nitride.

Example 6. A semiconductor device according to example 5, wherein the oxide is SiOₓ and the semiconductor substrate is formed of silicon, or wherein the oxide is SiOₓ, the nitride is silicon nitride and the semiconductor substrate is formed of silicon.

Example 7. A semiconductor device according to any one of examples 1 to 6, wherein the semiconductor substrate comprises an active region comprising a semiconductor device and an edge termination region that laterally surrounds the active region and the trench is formed in the edge termination region, wherein the trench has a ring-shape and laterally continuously surrounds the active region.

Example 8. A semiconductor device according to example 7, further comprising a transistor device formed in the active region.

Example 9. A semiconductor device according to example 8, wherein the active region comprises a plurality of active transistor cells, each active transistor cell comprising a columnar trench comprising a field plate and a mesa, wherein the field plate is electrically insulated from the semiconductor substrate by a second electrically insulating layer that lines the columnar trench.

Example 10. A semiconductor device according to example 9, wherein a third electrically insulating layer is arranged on the second electrically insulating layer, wherein the third electrically insulating layer laterally surrounds the field plate and has a lower surface that forms an interface with the second electrically insulating layer and an upper surface that is coplanar with the first major surface of the semiconductor substrate or that is positioned within the columnar trench.

Example 11. A semiconductor device according to any one of examples 1 to 10, wherein the edge termination region comprises:
a transition region laterally surrounding the active region and an outer termination region laterally surrounding the transition region,
a plurality of inactive cells arranged in the transition region and in the outer termination region), each inactive cell comprising a columnar termination trench comprising a field plate and a termination mesa comprising a drift region of a first conductivity type, wherein, in the transition region, the termination mesa comprises a body region of the second conductivity type arranged on the drift region and in the outer termination region the drift region of the termination mesa extends to the first surface;
wherein the trench is positioned in the outer termination region and laterally surrounds the columnar termination trenches.

Example 12. A semiconductor device according to example 11, further comprising a buried doped region of the second conductivity type that has a lateral extent such that it is positioned in the transition region and in the outer termination region.

Example 13. A semiconductor device according to example 12, wherein the buried doped region comprises an inner edge that is positioned under the body region in the transition region and an outer edge that is positioned outside of the continuous trench and the plurality of inactive cells in the outer termination region.

Example 14. A semiconductor device according to any one of examples 10 to 13, wherein, in the transition region, the buried doped region is vertically spaced apart from the body region of the termination mesa by a portion of the drift region.

Example 15. A semiconductor device according to any one of examples 10 to 14, wherein in the transition region the body region of the termination mesas extends to the first surface.

Example 16. A semiconductor device according to one of examples 10 to 15, wherein the continuous trench is spaced apart from an outermost columnar termination trench by a distance dₒᵤₜₑᵣ and 101 nm ≤ dₒᵤₜₑᵣ ≤ 2 µm, wherein the semiconductor substrate typically has a cuboid form with substantially perpendicular, substantially straight side faces, i.e. perpendicularly to the side faces, that intersect at corners and the distance dₒᵤₜₑᵣ is measured adjacent to the side faces rather than at the corners, i.e. diagonally from the corner.

Example 17. A semiconductor device according to one of examples 9 to 16, wherein each mesa of the active transistor cells comprises a drift region of a first conductivity type, a body region of a second conductivity type opposing the first conductivity type arranged on the drift region, a source region of the first conductivity type arranged on the body region and a gate trench comprising a gate electrode, wherein the gate trench extends through the source region and the body region into the drift region, wherein each of the columnar trenches extends from the first surface through the body region and into the drift region.

Example 18. A semiconductor device according to one of examples 9 to 17, further comprising at least one gate finger extending over the edge termination region to a gate runner that is positioned laterally between the side face of the semiconductor body and the continuous trench in the outer termination region.

Example 19. A semiconductor device according to example 18, further comprising a gate contact electrically coupling the gate runner to gate electrodes of the active transistor cells, wherein the gate contact is positioned above the body region in the transition region.

Example 20. A method of fabricating an electrically insulating structure in a trench, the method comprising:
forming a trench in a first major surface of a semiconductor substrate;
forming a first electrically insulating layer on the base and side walls of the trench;
forming an electrically insulating plug within the trench and on the first electrically insulating layer such that the plug has a lower surface forming an interface with the first electrically insulating layer and an upper surface that is coplanar with the first major surface of the semiconductor substrate or that is positioned within the trench.

Example 21. A method according to example 20, wherein the forming the first electrically insulating layer comprises thermally growing the first electrically insulating layer, or wherein the forming the first electrically insulating layer comprises thermally growing a first sublayer and then depositing a second sublayer on the first sublayer, wherein the second sublayer is deposited using a TEOS process.

Example 22. A method according to example 21, wherein the first electrically insulating layer is thermally grown to have a thickness such that it substantially fills the width of the trench and such that an interface is formed between the outer surface of the first electrically insulating layer located on opposing sections of the side wall of the trench.

Example 23. A method according to any one of examples 20 to 22, wherein the first electrically insulating layer is further formed on the first major surface of the semiconductor substrate.

Example 24. A method according to any one of examples 20 to 23, wherein the first electrically insulating layer is removed from the upper portion of the trench such that a recess is formed that exposes the side wall of the trench in the upper portion of the trench and the electrically insulating plug is formed in the recess.

Example 25. A method according to any one of examples 20 to 24, wherein the forming the electrically insulating plug comprises depositing a second electrically insulating layer onto the first major surface of the semiconductor substrate and into an upper portion of the trench and subsequently planarising to form a planarized surface comprising the material of the semiconductor substrate and the material of the electrically insulating plug.

Example 26. A method according to example 25, wherein the planarising comprises chemical mechanical polishing.

Example 27. A method according to any one of examples 20 to 26, wherein the electrically insulating plug is formed by a high plasma deposition process or a TEOS process.

Example 28. A method according to any one of examples 20 to 26, wherein the first electrically insulating layer is formed by oxidizing the semiconductor substrate and the electrically insulating plug is formed by a high plasma deposition process.

Example 29. A method according to any one of examples 20 to 28, wherein the first electrically insulating layer and the electrically insulating plug comprises silicon oxide.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor device, comprising:
a semiconductor substrate having a first major surface;
a trench positioned in the semiconductor substrate, the trench having a width and having a base and a side wall extending from the base to the first major surface;
a first electrically insulating layer that lines the base and side wall of the trench;
an electrically insulating plug that is positioned in the trench and that extends across the entire width of the trench;
wherein the plug has a lower surface that forms an interface with the first electrically insulating layer and an upper surface that is coplanar with the first major surface of the semiconductor substrate or that is positioned within the trench.

2. A semiconductor device according to claim 1, wherein the plug is in direct contact with the side wall of the trench or with a native oxide located on the side wall of the trench.

3. A semiconductor device according to claim 1 or claim 2, wherein the first electrically insulating layer has a surface and a thickness such that the surface of the first electrically insulating layer located on a first sidewall section abuts the surface of the first electrically insulating layer located on a second side wall section that opposes the first side wall section.

4. A semiconductor device according to claim 1 or claim 2, wherein the first electrically insulating layer and the electrically insulating plug surround a sealed cavity within the trench.

5. A semiconductor device according to any one of claims 1 to 4, wherein the first electrically insulating layer and the electrically insulating plug are each formed of an oxide, or the first electrically insulating layer comprises an oxide and the electrically insulating layer comprises a nitride.

6. A semiconductor device according to claim 5, wherein the first electrically insulating layer and the electrically insulating plug are each formed of SiOₓ and the semiconductor substrate is formed of silicon.

7. A semiconductor device according to any one of claims 1 to 6, wherein the semiconductor substrate comprises an active region comprising a semiconductor device and an edge termination region that laterally surrounds the active region and the trench is formed in the edge termination region, wherein the trench has a ring-shape and laterally continuously surrounds the active region.

8. A semiconductor device according to claim 7, wherein the active region comprises a plurality of active transistor cells, each active transistor cell comprising a columnar trench comprising a field plate and a mesa, wherein the field plate is electrically insulated from the semiconductor substrate by a second electrically insulating layer that lines the columnar trench.

9. A semiconductor device according to claim 8, wherein a third electrically insulating layer is arranged on the second electrically insulating layer, wherein the third electrically insulating layer laterally surrounds the field plate and has a lower surface that forms an interface with the second electrically insulating layer and an upper surface that is coplanar with the first major surface of the semiconductor substrate or that is positioned within the columnar trench.

10. A method of fabricating an electrically insulating structure in a trench, the method comprising:
forming a trench in a first major surface of a semiconductor substrate; the trench having a width, a base and a side wall extending from the base to the first major surface;
forming a first electrically insulating layer on the base and side walls of the trench;
forming an electrically insulating plug within the trench across the entire width of the trench and on the first electrically insulating layer such that the plug has a lower surface forming an interface with the first electrically insulating layer and an upper surface that is coplanar with the first major surface of the semiconductor substrate or that is positioned within the trench.

11. A method according to claim 10, wherein the forming the first electrically insulating layer comprises thermally growing the first electrically insulating layer or wherein the forming the first electrically insulating layer comprises thermally growing a first sublayer and then depositing a second sublayer on the first sublayer.

12. A method according to claim 11, wherein the first electrically insulating layer is thermally grown to have a thickness such that it substantially fills the width of the trench and such that an interface is formed between the outer surface of the first electrically insulating layer located on opposing sections of the side wall of the trench.

13. A method according to any one of claims 10 to 12, wherein the first electrically insulating layer is removed from the upper portion of the trench such that a recess is formed that exposes the side wall of the trench in the upper portion of the trench and the electrically insulating plug is formed in the recess.

14. A method according to any one of claims 10 to 13, wherein the forming the electrically insulating plug comprises depositing a second electrically insulating layer onto the first major surface of the semiconductor substrate and into an upper portion of the trench and subsequently planarising to form a planarized surface comprising the material of the semiconductor substrate and the material of the electrically insulating plug.

15. A method according to any one of claims 10 to 14, wherein the electrically insulating plug is formed by a high plasma deposition process or a TEOS process.
